Europäisches Patentamt

European Patent Office

Office européen des brevets

(19)

(11) Publication number : **0 512 742 A1**

(12) **EUROPEAN PATENT APPLICATION**

(21) Application number : 92303867.3

(22) Date of filing : 29.04.92

(51) Int. Cl.⁵ : **H01L 23/48,** H01L 23/051

(30) Priority : 02.05.91 GB 9109542

(43) Date of publication of application :
11.11.92 Bulletin 92/46

(84) Designated Contracting States :
DE FR GB IT

(71) Applicant : **SEMITRON INDUSTRIES LIMITED**
**Chelworth Industrial Estate, Cricklade**
**Swindon, Wiltshire SN6 6HQ (GB)**

(72) Inventor : **Hughes, Rhodri Gareth**
**141 Morris Street**
**Swindon, Wiltshire SN2 2HS (GB)**
Inventor : **Loader, Kelvin**
**103 Rodden Road**
**Frome, Somerset BA11 2AJ (GB)**

(74) Representative : **Allam, Peter Clerk**
**LLOYD WISE, TREGEAR & CO. Norman House**
**105-109 Strand**
**London WC2R 0AE (GB)**

(54) **Semiconductor device assembly.**

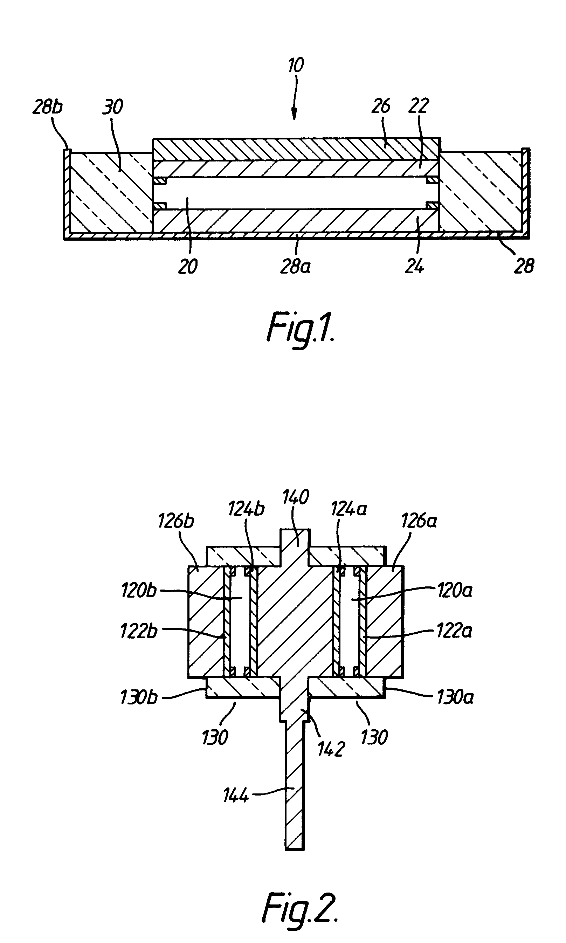

(57)    A planar semiconductor die (20) within which a diode is formed, is mounted in an enclosure without any internal soldering. External contact is made to the opposite surfaces of the die (20) through electrodes (26, 28) press-fitted to a supporting insulator body (30) within which the die (20) is received. Soft metal inserts (22, 24) of aluminium are placed between the die surfaces and the electrodes (26, 28) and take up any irregularities on the internal electrode surfaces. The assembly is entirely mechanical. The press-fitting of the electrodes (26, 28) provides the internal contact pressure. A symmetrical back-to-back diode assembly (Fig. 2) is also disclosed.

Fig.1.

EP 0 512 742 A1

Jouve, 18, rue Saint-Denis, 75001 PARIS

This invention relates to the packaging or enclosing of semiconductor devices.

A particular concern of the invention is with packages or enclosures for a body of semiconductor material, such as a die (chip) or other planar substrate, in which electrical contact is to be made to both sides of the body. Examples of such bodies are diodes, especially those which may be called on to operate at a moderate or greater voltage and/or current level. In such cases the semiconductor device provides a single diode formed within the body of semiconductor material, the latter usually being silicon. Such diodes are commonly found in modular protector units used in the telecommunication industry for surge and transient protection, and are finding growing use in automotive electrics.

The diodes used may be of various types, including multi-junction types, for example transient-suppressing Zener diodes, Shockley diodes, foldback diodes, rectifying diodes, and two terminal thyristors.

The current packaging techniques for such surge and transient protection devices commonly enclose the device in a plastic moulding, a glass enclosure or a metal can. With all these conventional techniques it has been necessary to employ at least one soldered, welded or bonded connection between the semiconductor body within the enclosure and the external contacts of the device. Particular care is required with soldered joints in transient suppressor devices to ensure there are no voids in the joint reducing the conductive quality of the joint.

There will be described hereinafter an embodiment of the present invention which provides a semiconductor device assembly having an enclosure for a semiconductor body requiring no internal soldered, bonded or welded joints. Contact is made and maintained by mechanical pressure achieved by the assembly structure and the manner in which it is formed. More particularly, the embodiment to be described utilises a semiconductor device having a substantial active area to which a good area contact is made. The embodiment has been particularly developed for transient suppressor devices for use in the applications discussed above. However, the assembly of the invention may have wider utility. It will also be shown how the process of assembly may be performed using only mechanical steps.

Aspects and features of the invention are set out in the claims following this description.

For a better understanding of the invention and its practice, embodiments will now be described with reference to the accompanying drawing in which:

Fig. 1 shows a diametric section through a circularly symmetrical diode assembly; and

Fig. 2 shows a similar section of an assembly comprising two diodes.

The assembly 10 of Fig. 1 comprises a semiconductor body 20 sandwiched between and in direct contact with discs 22 and 24 through which electrical connection is made to first and second external contact members 26 and 28 respectively with which discs 22 and 24 are also in direct contact. The discs 22 and 24 are of a relatively soft conductive material capable of deforming under pressure. A soft metal such as aluminium is suitable. Thus the electrical path of the device extends between contacts 26 and 28 through the semiconductor body. The semiconductor body may be a circular die but square or hexagonal dies are also common. The parts 22, 24, 26 and 28 are all disc-like, specifically of a circular form in the illustrated case, and parts 20-26 are received in the circular aperture of a relatively thick annular insulator body 30. The contact member 28 is cup-shaped and the insulator 30 is received within the cup as a close press fit around its whole periphery.

The semiconductor body may incorporate a diode of the kind discussed above in which conduction through the diode is between the opposite planar faces of the body. The body 20 is typically of monocrystalline silicon which has very flat surfaces. These surfaces may have a thin metallic plating applied.

The metal contact discs 22 and 24 and the semiconductor body 20 are a snug fit within the central cavity of the insulator 28. The lower disc provides a connection to the base 28a of the cup-shaped external contact member 28. The other external contact is provided by the disc 26 which is press fitted into the insulator cavity and has a sufficient thickness to stand proud of the surface of insulator 30 and the lip 28b of the cup-shaped member 28. The member 26 is likewise a close press-fit within the insulator around its whole periphery. The complete assembly forms a button-type of package. The press-fittings of the contact cup member 28 and the contact disc member 26 are sufficiently tight as to ensure the requisite pressure is applied to the internal assembly to provide the good electrical contact to the semiconductor body 20.

The external contact members 26 and 28 may be of nickel-plated copper. The insulator body 30 is preferably of a ceramic material.

The assembly process for the device described is as follows. The ceramic insulator 30 is press-fitted into the cup-shaped member 28. The soft metal disc 24, semiconductor body 20 and soft metal disc 22 are then inserted as a stack into the central cavity of the insulator body 30. Finally the electrode 26 is press fitted into this cavity to compress the sandwich of parts 20, 22, 24 between the two external contact members secured to the insulator body by their respective press fits. The use of soft metal for the intermediate contacts 22 and 24 enables those parts to deform under the applied pressure to take up any surface irregularities in the mating surfaces of the harder external contacts and thereby enhances good contact over the whole active area of the semiconductor body. If the intermediate contacts were omitted and the inner surfaces of the external contacts were to mate with the semiconductor surfaces directly, these inner surfaces would need to be prepared to a much finer finish (the semiconductor surfaces are expected to be very flat) and the surfaces would have to align very accurately to obtain the desired broad area contact over the semiconductor body. The whole assembly process is well-suited for automation and for performance as an entirely mechanical assembly of parts. The absence of soldering avoids the need to move the device assemblies to a soldering or brazing station.

The described device thus achieves both mechanical integrity in providing an enclosure for the semiconductor body and electrical integrity of connection between the semiconductor body and the external contacts by mechanical operations only, specifically the application of pressure to parts of the assembly. No internal soldering, welding or bonding operations are required. Nor is there any soldering, brazing, welding or other such bonding operation required between the external contact members and the housing body 30 or between the stack of parts between the contact members and the housing. The assembly described is entirely mechanically secured. In the construction described no additional springs or the like are used to obtain the necessary internal contact pressure. It will be appreciated that if a leaded device were required then leads could be attached as by soldering to the external surfaces of the electrodes 26 and 28.

By virtue of the close fit between the external contact members and the insulator body around their entire circumferences the assembly described also provides a well-sealed enclosure for the semiconductor body 20 itself.

Assembly shapes other than circular could be employed. If sealing against dirt or moisture were not a problem in a particular application, then an exact fit around the complete periphery between the external contact members and the insulator body may not be necessary.

A modification of the above construction would be to replace the cup-shaped electrode by a second interior press-fit disc-like electrode. Fig. 2 shows a three-terminal assembly which may be regarded as two of the modified assemblies mounted back-to-back in a unitary construction.

The device shown in Fig. 2 uses the press-fitting method of assembly described above with soft metal inserts providing good area contact between semiconductor chips and the external contact members.

In Fig. 2 two diode semiconductor bodies 120a and 120b are shown connected in series in a back-to-back configuration between external electrodes 126a and 126b. A third external electrode 140 is interposed between the semiconductor chips 120a and 120b. To provide good area contact between the three external electrodes and the adjacent chip surfaces, soft metal discs are interposed as already described. These are denoted 122a and 124a, and 122b and 124b respectively. The insulator housing 130 is in two tubular parts 130a and 130b. Each short tubular part receives a respective electrode 126a and 126b as a press fit in its outer end. The centre electrode 140 is of circular section with a central protruding flange 142 which serves to locate the inner ends of parts 130a and 130b on opposite sides of the flange. The end portions of the body of the electrode 140 are press fitted into the tubular housing parts. Electrode 140 may carry a connection tag 144.

Preferably assembly starts by fitting the parts 130a, 130b to the centre electrode 140, and is completed by press fitting the outer electrodes 126a, 126b into parts 130a, 130b to apply the necessary pressure to the interior components 120a, 120b, 122a, 122b, 124a and 124b which are a snug fit within the housing as already discussed.

The discs 122a, 122b, 124a and 124b may be of aluminium as abovementioned, the housing parts of ceramic and the electrodes of nickel-plated copper. The press-fit, pressure-maintained, connections from the external contacts to the semiconductor bodies by way of the soft metal inserts in direct contact with the adjacent elements avoid the need to fine finish the interior surfaces of electrodes 126a and 126b and the opposite surfaces of electrode 140.

## Claims

1. A semiconductor device assembly comprising an insulator body having an inner cavity, a plurality of parts comprising in sequence a first external contact member, a semiconductor body, a second external contact member, and a conductive member of relatively soft material interposed between at least one external contact member and the semiconductor body, said semiconductor body and the interposed conductive member or members being disposed under compression within said insulator body cavity between said first and second contact members, and one of said external contact members being press fitted to said insulator body to secure said one contact member to said insulator body.

2. An assembly as claimed in Claim 1 in which a respective conductive member of relatively soft material is interposed between each external contact member and the semiconductor body.

3. An assembly as claimed in Claim 1 or 2 in which the other of said external contact members is press fitted to said insulator body.

4. An assembly as claimed in Claim 1, 2 or 3 in which at least one of said contact members is a press fit in the cavity of said insulator body.

5. An assembly as claimed in Claim 1 or 2 in which at least one of said contact members is cup-shaped and said insulator body is a press fit therein.

6. A semiconductor device assembly as claimed in Claim 1 or 2 in which said cavity extends between opposite surfaces of the insulator body, one of said contact members being a press-fit in the cavity and the other of said contact members defining a recess within which the insulator body is a press fit whereby the press fitting of the respective external contact members to the insulator body provide the compression force to the semiconductor body and the interposed conductive member or members.

7. A semiconductor device assembly as claimed in Claim 6 in which said second external contact member is cup-shaped and said insulator body is a press-fit within the cup.

8. A semiconductor device assembly as claimed in any one of Claims 1 to 7 in which said first contact member stands proud of the insulator body.

9. A semiconductor device assembly comprising a stack of parts through which an electrical path extends, said stack comprising a semiconductor body, external contact members at opposite sides of the semiconductor body and an electrically conductive member interposed between at least one contact member and the adjacent side of the body, said conductive member or members and the semiconductor body being subject to a compressive force between the external contact members, and the or each conductor member being of a relatively soft conductive material to allow deformation thereof to provide good area contact between the adjacent semiconductor body and external contact member surfaces, and in which said external contact members are secured to a support body encircling said semiconductor body, at least one of said external contact members being press fitted to the body to generate said compressive force.

10. A semiconductor device assembly as claimed in Claim 9 in which said semiconductor body and conductive member or members are planar parts.

Fig.1.

Fig.2.

# EP 0 512 742 A1

**European Patent Office**

## EUROPEAN SEARCH REPORT

Application Number

EP 92 30 3867

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | US-A-4 305 087 (INTERN. RECTIFIER) <br> * column 2, line 51 - line 68; figure 2 * | 1 | H01L23/48 <br> H01L23/051 |
| A | | 4-10 | |
| A | EP-A-0 365 007 (TOSHIBA) <br> * column 13, line 15 - line 26; figure 11 * | 1,2,10 | |
| A | EP-A-0 122 431 (SIEMENS) <br><br> * claim 1; figure 3 * | 1,3,4,6, 9,10 | |
| A | GB-A-2 157 487 (MARCONI) <br><br> ----- | | |
| | | | **TECHNICAL FIELDS SEARCHED (Int. Cl.5 )** <br><br> H01L |

The present search report has been drawn up for all claims

| Place of search | Date of completion of the search | Examiner |
|---|---|---|
| THE HAGUE | 23 JULY 1992 | DE RAEVE R.A.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

6